# EUROPEAN PATENT APPLICATION

(11) **EP 4 737 784 A1**
(43) Date of publication of application: **06.05.2026**
(21) Application number: 24879939.7
(22) Date of filing: 26.08.2024
(51) Int. Cl.: F16M 11/04

(54) **DISPLAY APPARATUS**

(30) Priority: 19.10.2023 KR 20230140717; 08.01.2024 KR 20240003144
(71) Applicant: Samsung Electronics Co., Ltd., Suwon-si, Gyeonggi-do 16677 (KR)
(72) Inventor: KIM, Jangho, Suwon-si Gyeonggi-do 16677 (KR); NA, Sanghyeon, Suwon-si Gyeonggi-do 16677 (KR); LEE, Jaeneung, Suwon-si Gyeonggi-do 16677 (KR); LEE, Sangyoung, Suwon-si Gyeonggi-do 16677 (KR); KIM, Kihong, Suwon-si Gyeonggi-do 16677 (KR)
(74) Representative: Appleyard Lees IP LLP
(86) International application number: PCT/KR2024/012712
(87) International publication number: WO 2025/084599

(57) **Abstract**

A display apparatus including a stand configured to support a display, the stand including a stand base configured to be supported on a support surface, the stand base including an inclined portion configured to be inclined at a predetermined angle with respect to the support surface when the stand base is supported on the support surface, and a stand neck configured to connect a rear surface of the display and the stand base to support the display on the stand, the stand neck including a reflective portion that is connected to the inclined portion so that the reflective portion is perpendicular to the inclined portion, wherein the reflective portion is configured to reflect the inclined portion.

## Description

### [Technical Field]

The disclosure relates to a display apparatus including a stand.

### [Background Art]

In general, a display apparatus is a type of output device that converts acquired or stored electrical information into visual information and displays such information to a user, and is used in various fields, such as homes and businesses.

Display apparatuses may be classified into two types: self-emissive, which includes display panels that emit light by themselves, such as organic light emitting diodes (OLEDs), and non-emissive, which includes display panels that do not emit light by themselves and must be supplied with light from a backlight unit (BLU), such as liquid crystal displays (LCDs).

A display apparatus may include a display arranged to display a screen, and a support arranged to support the display. The support may include a wall mount for supporting the display so that the display is mounted on a wall, and a stand for supporting the display so that the display is placed on a piece of furniture or on the floor.

The wall mount is located behind the display and is not visible to the user, but the stand is visible to the user, so the stand may affect the overall appearance of the display apparatus.

### [Disclosure]

### [Technical Problem]

One aspect of the present disclosure provides a display apparatus that allows a user to focus on a screen of a display by reducing the presence of a stand.

Technical tasks to be achieved in this document are not limited to the technical tasks mentioned above, and other technical tasks not mentioned will be clearly understood by those skilled in the art from the description below.

### [Technical Solution]

According to an embodiment of the disclosure, a display apparatus includes a stand configured to support a display, the stand including a stand base configured to be supported on a support surface, the stand base including an inclined portion configured to be inclined at a predetermined angle with respect to the support surface when the stand base is supported on the support surface, and a stand neck configured to connect a rear surface of the display and the stand base to support the display on the stand, the stand neck including a reflective portion that is connected to the inclined portion so that the reflective portion is perpendicular to the inclined portion, wherein the reflective portion is configured to reflect the inclined portion.

### [Description of Drawings]

FIG. 1 is a perspective view of a display apparatus, according to an embodiment.
FIG. 2 is a rear perspective view of the display apparatus, according to an embodiment.
FIG. 3 is an enlarged view of a portion of the display apparatus, according to an embodiment.
FIG. 4 is a perspective view of a stand of the display apparatus, according to an embodiment.
FIG. 5 is a side view of the stand of the display apparatus, according to an embodiment.
FIG. 6 is a top view of the stand of the display apparatus, according to an embodiment.
FIG. 7 is a perspective view of a display apparatus, according to an embodiment.
FIG. 8 is a rear perspective view of the display apparatus, according to an embodiment.
FIG. 9 is an enlarged view of a portion of the display apparatus, according to an embodiment.
FIG. 10 is a perspective view of a stand of the display apparatus, according to an embodiment.
FIG. 11 is a side view of the stand of the display apparatus, according to an embodiment.
FIG. 12 is a top view of the stand of the display apparatus, according to an embodiment.
FIG. 13 is a perspective view of a display apparatus, according to an embodiment.
FIG. 14 is a rear perspective view of the display apparatus, according to an embodiment.
FIG. 15 is a perspective view of a stand of the display apparatus, according to an embodiment.
FIG. 16 is a side view of the stand of the display apparatus, according to an embodiment.
FIG. 17 is an exploded view of a stand of the display apparatus, according to an embodiment.
FIG. 18 is a perspective view of the stand shown in FIG. 17.
FIG. 19 is an enlarged view of a portion of the display apparatus, according to an embodiment.
FIG. 20 is a perspective view of a stand of the display apparatus, according to an embodiment.
FIG. 21 is a perspective view of a stand of the display apparatus, according to an embodiment.

### [Mode of the Disclosure]

Various embodiments of the present document and terms used therein are not intended to limit the technical features described in this document to specific embodiments, and should be understood to include various modifications, equivalents, or substitutes of the corresponding embodiments.

In connection with the description of the drawings, similar reference numerals may be used for similar or related components.

The singular form of a noun corresponding to an item may include one or a plurality of the items unless clearly indicated otherwise in a related context.

In this document, phrases, such as "A or B", "at least one of A and B", "at least one of A or B," "A, B or C," "at least one of A, B and C," and "at least one of A, B, or C", may include any one or all possible combinations of items listed together in the corresponding phrase among the phrases.

As used herein, the term "and/or" includes any and all combinations of one or more of associated listed items.

Terms such as "1st", "2nd", or "first", "second", or "primary", "secondary" may be used simply to distinguish a component from other components, without limiting the component in other aspects (e.g., importance or order).

When a component (e.g., a first component) is referred to as "coupled" or "connected" to another component (e.g., a second component), with or without the terms "functionally" or "communicatively," it may refer to that the component may be connected to another component directly (e.g., wired), wirelessly, or through a third component.

It will be understood that when the terms "includes," "comprises," "including," and/or "comprising," when used in this specification, specify the presence of stated features, figures, steps, operations, components, members, or combinations thereof, but do not preclude the presence or addition of one or more other features, figures, steps, operations, components, members, or combinations thereof.

It will be understood that when a certain component is referred to as being "connected to", "coupled to", "supported by" or "in contact with" another component, it can be directly or indirectly connected to, coupled to, supported by, or in contact with the other component. When a component is indirectly connected to, coupled to, supported by, or in contact with another component, it may be connected to, coupled to, supported by, or in contact with the other component through a third component.

It will also be understood that when a component is referred to as being "on" or "over" another component, it can be directly on the other component or intervening components may also be present.

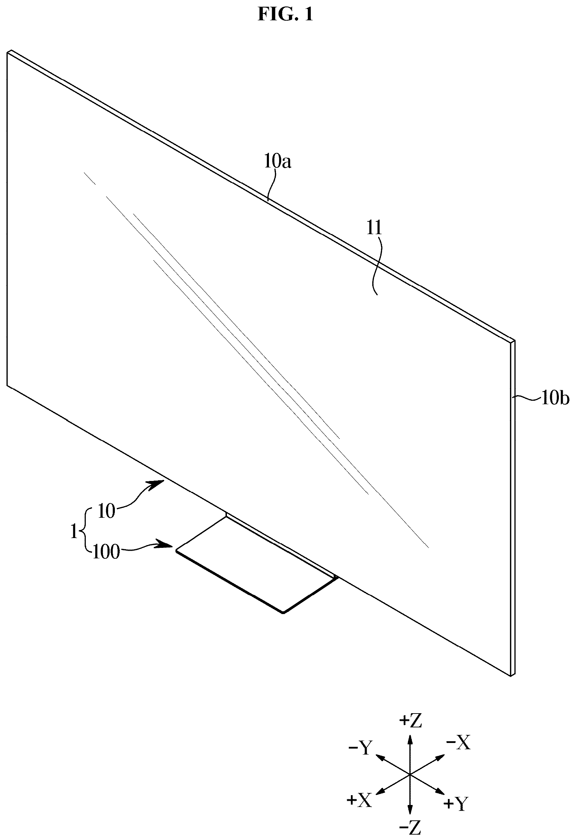

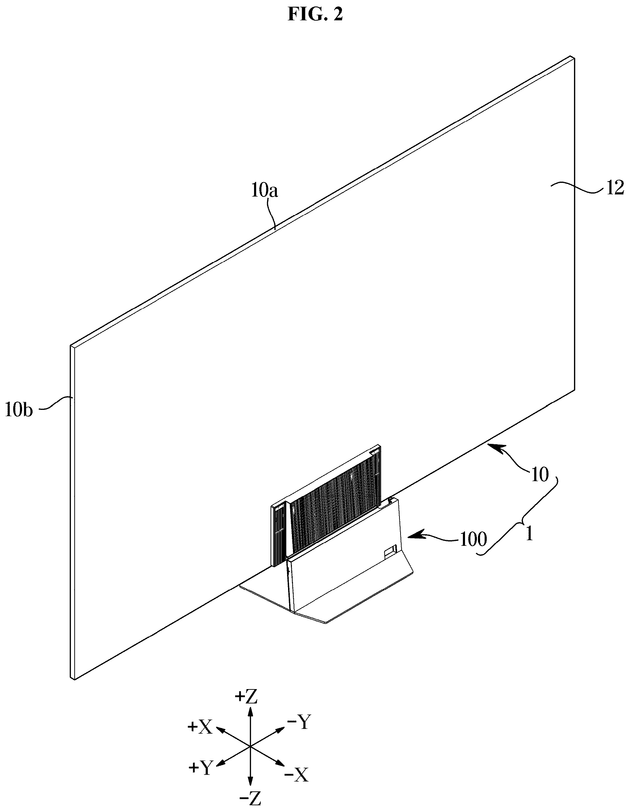

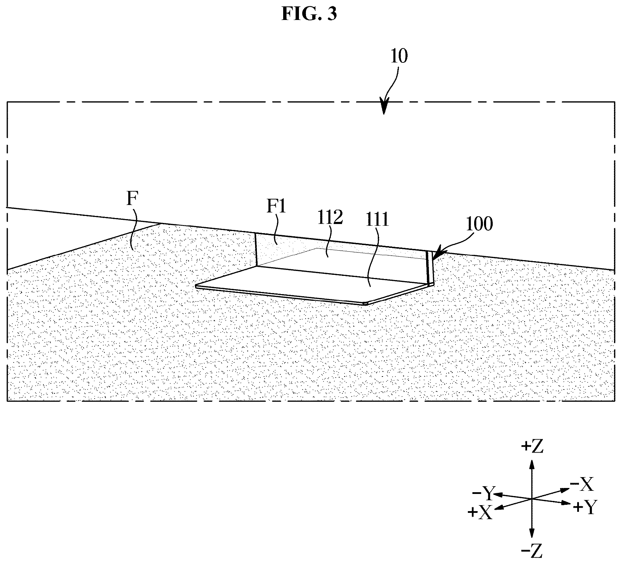

FIG. 1 is a front perspective view of a display apparatus, according to an embodiment. FIG. 2 is a rear perspective view of the display apparatus, according to an embodiment. FIG. 3 is an enlarged view of a portion of the display apparatus, according to an embodiment.

As used herein, a +X direction shown in the drawings may refer to a front, and a -X direction may refer to a rear. A +Y direction may refer to a left side, and a -Y direction may refer to a right side. A +Z direction may refer to an upper side and a -Z direction may refer to a lower side.

Referring to FIGS. 1 and 2, a display apparatus 1 according to an embodiment may include a display 10 that displays a screen 11 and a stand 100 provided to support the display 10.

The display 10 may be a device that displays information, materials, data, or the like in the form of text, shapes, graphics, images, or the like, and may include a television, a monitor, or the like.

The display 10 may be configured to display the screen 11. The display 10 may include a self-emissive display panel (not shown), such as an organic light emitting diode (OLED) or a non-emissive display panel (not shown), such as a liquid crystal display (LCD). There is no particular limitation on the type of display panel. Accordingly, the display may include different types of display panels.

The display 10 may include a case 12 provided to cover an edge and a rear surface of the screen 11. The display panel described above, a control board (not shown), and various components may be arranged on an inner side of the case 12.

The display 10 may be provided to have a different horizontal and vertical side lengths. The display 10 may be arranged to have a long side 10a and a short side 10b. The display 10 may be provided in the shape of a rectangular plate. However, the present disclosure does not exclude that the display 10 may be provided in the shape of a square plate.

The stand 100 may support the display 10 such that the display apparatus 1 may stand on its own (or self-standing) on a floor F (e.g., a floor surface). The stand 100 may be coupled to a rear surface of the display 10. When the stand 100 is coupled to the display 10, the display 100 may maintain the screen 11 facing forward. Self-standing of the display apparatus 1 may refer to that the display apparatus 1 is placed on the floor with the screen 11 of the display 10 remaining facing forward.

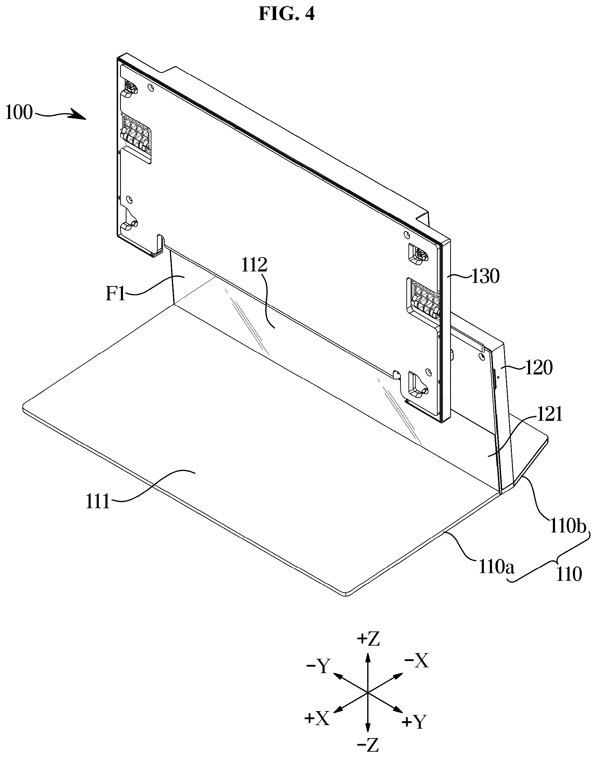

As illustrated in FIG. 4, described herein, the stand 100 may include a stand base 110 provided to rest on the floor F (or other such surface upon which the stand 100 is supported, such as the top of a desk), and a stand neck 120 provided to connect the display 10 and the stand base 110.

The stand base 110 may include an inclined portion 111 disposed to be inclined at a predetermined angle with respect to the floor F. The stand neck 120 may include a reflective portion 121 connected to the inclined portion 111 so as to be disposed perpendicular to the inclined portion 111. The inclined portion 111 may indicate at least a portion of an upper surface of the stand base 110. The reflective portion 121 may indicate at least a portion of a front surface of the stand neck 120 or a configuration coupled to the front surface of the stand neck 120.

Referring to FIG. 3, when the display apparatus 1 is upright on its own, the presence of the stand 100 may be reduced or eliminated so that the user may focus solely on the screen 11 of the display 10.

As described above, the inclined portion 111 of the stand base 110 may be disposed to be inclined at an angle predetermined by experiments and studies with respect to the floor F. The reflective portion 121 of the stand neck 120 may be arranged perpendicular to the inclined portion 111, and the reflective portion 121 may be arranged to reflect the inclined portion 111. The reflective portion 121 may be configured to reflect and illuminate an object located in front of the reflective portion 121. The reflective portion 121 may include a metal mirror or a glass mirror formed by polishing a surface of a metal.

As the inclined portion 111 is disposed to be inclined at a predetermined angle with respect to the floor F, the reflective portion 121 is connected perpendicularly to the inclined portion, and the reflective portion 121 reflects an object located in front of the reflective portion 121, the display 10 may appear to be floating over the floor F to a user looking at the display apparatus 1 from the front. In other words, to the user, the inclined portion 111, which is a portion of the stand base 110, may be placed on the floor F, and the display 10 may appear to be floating. To the user, the stand neck 120 connecting the stand base 110 and the display 10 may appear to be non-existent. As a result, the presence of the stand 100 may disappear, and the user may focus solely on the screen 11 of the display 10. In the following, the principle of making the display 10 appear to the user as if it were floating in the air, thereby making the presence of the stand 100 disappear, will be described.

Referring to FIG. 3, when the user looks at the stand 100 from the front, the floor F on which the stand 100 is placed, the inclined portion 111 that is a portion of the stand 100, an inclined portion 112 reflected by the reflective portion 121, and a floor F1 reflected by the reflective portion 121 may be seen by the user. In other words, the stand neck 120 may not be visible to the user, but the inclined portion 112 and the floor F1 reflected by the reflective portion 121 of the stand neck 120 may be visible. In the descriptions herein, the term "floor" may refer to a surface upon which the stand 100 rests or otherwise contacts. Such a surface may also be referred to as a support surface herein.

In the disclosure, the inclined portion 111 reflected and illuminated by the reflective portion 121 may be referred to as a reflective inclined portion 112. In addition, the floor F reflected and illuminated by the reflective portion 121 may be referred to as a reflective floor F1. The reflective inclined portion 112 may refer to an inclined portion that is reflected by the reflective portion 121 and is visible to the user, rather than the actual inclined portion 111. The reflective floor F1 may refer to a floor surface that is reflected by the reflective portion 121 and is visible to the user, rather than the actual floor F.

Because the reflective portion 121 of the stand neck 120 reflects the inclined portion 111 and the floor F, the stand neck 120 may not be visible to the user looking at the stand 100. The user may see the inclined portion 111, the reflective inclined portion 112, the floor F, and the reflective floor F1, wherein the inclined portion 111 and the reflective inclined portion 112 may appear to be connected as if they were a single plate, and the floor F and the reflective floor surface F1 may appear to surround the inclined portion 111 and the reflective inclined portion 112. As a result, to the user, the stand 100 may appear to be a plate placed on the floor. In this case, the floor may refer to the floor F and the reflective floor F1, which appear to be connected to each other, and the plate may refer to the inclined portion 111 and the reflective inclined portion 112, which appear to be a single plate. The inclined portion 111 and the reflective inclined portion 112 may appear to be a single plate, and the single plate may appear to be placed on the floor F and the reflective floor F1, which appear to be the same floor.

As the stand 100 appears to be a plate placed on the floor, the display 10 may appear to float over the plate. By making the display 10 appear to be floating on the plate placed on the floor, the presence of the stand 100, which was present as a dark silhouette at a lower end portion of the display apparatus 1, may disappear, thereby creating the effect that the display 10 appears to be floating in the air. The disappearance or reduced presence of the stand 100 may allow the user to focus more on the screen 11 of the display 10, which is the essence of the display apparatus 1.

To achieve the above effect, the inclined portion 111 of the stand base 110 may be disposed to be inclined at an angle predetermined by studies and experiments with respect to the floor F, and the reflective portion 121 of the stand neck 120 and the inclined portion 111 may be connected at exactly 90°. By connecting the reflective portion 121 and the inclined portion 111 at exactly 90°, the sides of the inclined portion 111 and the reflective inclined portion 112 may be connected in a straight line such that the inclined portion 111 and the reflective inclined portion 112 appear to be a single plate. By arranging the inclined portion 111 to be inclined at a predetermined angle with respect to the floor F, the user or unneeded objects may not be reflected in the reflective portion 121, thereby creating the effect of the display 10 floating in the air.

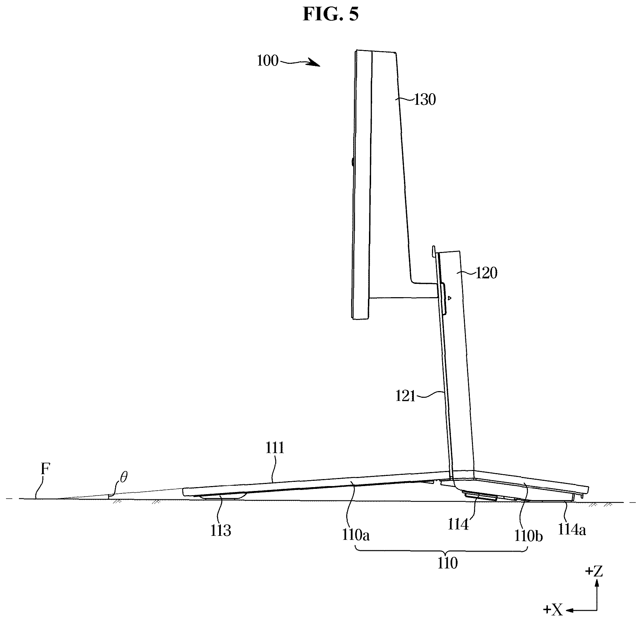

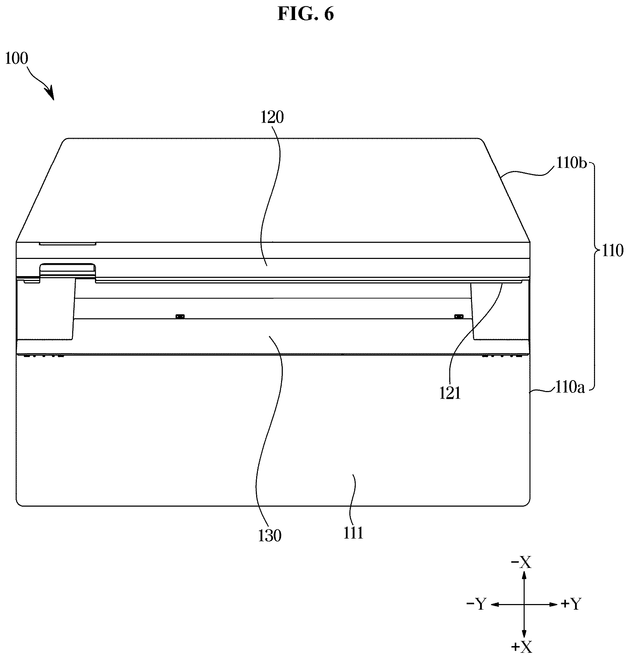

FIG. 4 is a perspective view of the stand of the display apparatus, according to an embodiment. FIG. 5 is a side view of the stand of the display apparatus, according to an embodiment. FIG. 6 is a top view of the stand of the display apparatus, according to an embodiment.

Referring to FIGS. 4 to 6, a structure of the stand 100 configured to reduce the presence of the stand 100 in the display apparatus 1 will be described as an example.

Referring to FIG. 4, the stand 100 according to an embodiment may include the stand base 110 arranged to be placed on the floor F, and the stand neck 120 arranged to connect the display 10 and the stand base 110.

The stand base 110 may be arranged to be in contact with the floor F. The stand base 110 may be in contact with the floor F by being placed on the floor F.

According to an embodiment, the stand base 110 may include a front base 110a disposed on a front side of the stand neck 120 and a rear base 110b disposed on a rear side of the stand neck 120.

A portion of a lower surface of the front base 110a may be provided to contact the floor F. A portion of a lower surface of the rear base 110b may be provided to contact the floor F. A first support 113 provided on a front end side of the lower surface of the front base 110a may be provided to contact the floor F, and a second support 114a provided on a rear end side of the lower surface of the rear base 110b may be provided to contact the floor F. The upper and lower surfaces of the front base 110a may each be disposed to be inclined with respect to the floor F. The upper and lower surfaces of the rear base 110b may each be disposed to be inclined with respect to the floor F. The rear base 110b may further include a third support 114 for more stable contact with the floor F. The third support 114 may be positioned in front of the second support 114a.

Such a structure may allow at least a portion of the lower surface of the stand 100 according to an embodiment to be disposed in an inclined manner with respect to the floor F. As the lower surface of the stand 100 is disposed at an angle with respect to the floor F, at least a portion of the lower surface of the stand 100 may not be in contact with the floor F. In other words, the first support 113, the second support 114a, and the third support 114 arranged on the lower surface of the stand 100 may be in contact with the floor F, and the lower surface of the stand 100 except for the first to third supports may not be in contact with the floor F.

The upper surface of the front base 110a may indicate the inclined portion 111 described above. According to an embodiment, the upper surface of the front base 110a may have a rectangular shape. However, there is no limitation on the shape of the upper surface of the front base 110a. For example, the upper surface of the front base 110a may have a variety of shapes.

Referring to FIG. 6, a rear base 110b may be provided such that its width gradually narrows toward the rear. The width of the rear base 110b may refer to a length of the rear base 110b in a left-to-right direction. Although not shown in the drawings, the rear base 110b may be provided to include a portion whose width gradually narrows toward the rear. In this case, the rear base 110b may include a section whose width narrows toward the rear from a front end of the rear base 110b connected to the stand neck 120, and after the section, the width may be constant or wider.

According to an embodiment, the stand 100 may include a coupling plate 130 to be coupled to the case 12 of the display 10. The coupling plate 130 may be coupled to the display 10 and the stand neck 120. The coupling plate 130 may be coupled to the rear surface of the display 10 by various known methods.

The coupling plate 130 may be formed integrally with the stand neck 120 or may be arranged to be coupled to the stand neck 120. For ease of description, the coupling plate 130 is described as a separate designation, but the coupling plate 130 may refer to a portion of the stand neck 120. In other words, the stand neck 120 may include the coupling plate 130.

The stand neck 120 may connect the display 10 and the stand base 110. The stand neck 120 may be formed integrally with the stand base 110 or may be arranged to be coupled to the stand base 120.

The stand neck 120 may be provided with the reflective portion 121 on the front surface thereof. The reflective portion 121 may be a metal mirror formed by polishing the surface of metal. For example, the reflective portion 121 may be a stainless super mirror. That is, the reflective portion 121 may be made of stainless steel with a surface treatment.

The reflective portion 121 may also be provided as a glass mirror. In this case, the reflective portion 121 may be configured to be attached to the front surface of the stand neck 120.

The reflective portion 121 may be connected to the inclined portion 111. The reflective portion 121 may be connected to the inclined portion 111 by contacting a lower end of the reflective portion 121 with the inclined portion 111. The reflective portion 121 may be disposed at 90° to the inclined portion 111. In other words, the reflective portion 121 may be disposed perpendicular to the inclined portion 111.

In the display apparatus 1 according to the present disclosure, the inclined portion 111 may be disposed to be inclined at a predetermined angle with respect to the floor F. In particular, the inclined portion 111 may be arranged to be inclined at an angle of 5° or less with respect to the floor F. The predetermined angle described above may refer to an angle of 5° or less. The fact that the inclined portion 31 is disposed to be inclined at an angle of 5° or less with respect to the floor F may refer to that the acute angle θ between the inclined portion 31 and the floor F is 5° or less.

The angle between the inclined portion 111 and the floor F may be determined by various experiments and studies. The angle may be determined by a number of experiments based on various variables, such as an average viewing height and a suitable viewing distance. According to the present disclosure, the angle between the inclined portion 111 and the floor F may be determined by comprehensively considering the height of the furniture on which the display apparatus 1 is placed, the height of the user's gaze when the user sits on a couch, the size of the screen 11 of the display apparatus 1, a distance between the display apparatus 1 and the user, the average height of the user, and the like. Through a series of experiments considering these variables, the angle between the inclined portion 111 and the floor F may be determined to be 5° or less. For example, the angle between the inclined portion 111 and the floor F may be 2° to 5°.

As the angle between the inclined portion 111 and the floor F becomes greater than 5°, the size of the reflective inclined portion 112 reflected by the reflective portion 121 may gradually increase. In response to the angle between the inclined portion 111 and the floor F exceeding a certain value, only the inclined portion 111 may be reflected by the reflective portion 121. In order for the display 10 to appear to be floating, the reflective floor F1 is required to be reflected by the reflective portion 121. As described above, as the angle between the inclined portion 111 and the floor F becomes greater than 5°, the reflective floor F1 on the reflective portion 121 may become too small or not be visible at all, so that the display 10 may not appear to be floating. Accordingly, it is difficult to make the presence of the stand 100 disappear.

In the display apparatus 1 according to the present disclosure, the angle between the inclined portion 111 and the floor F may be set to 5° or less, so that the display 10 may appear to be floating, the presence of the stand 100 may disappear, and the user may focus on the screen 11 of the display 10.

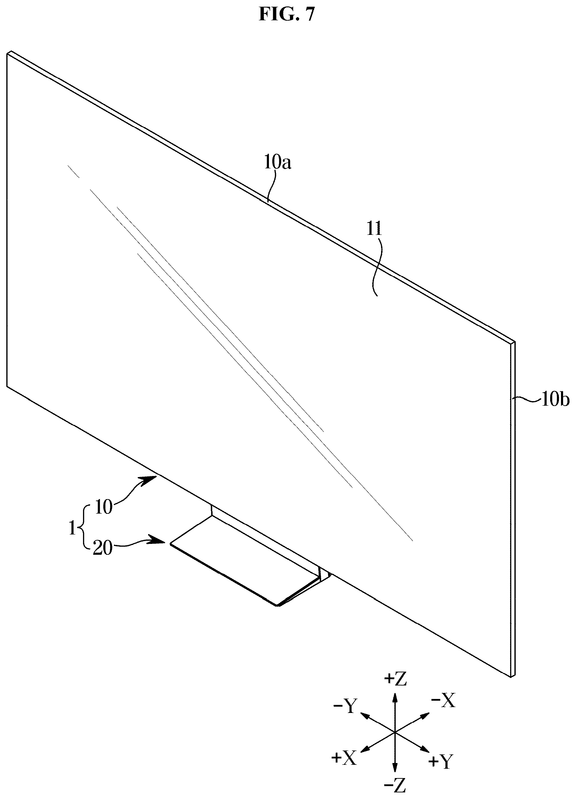

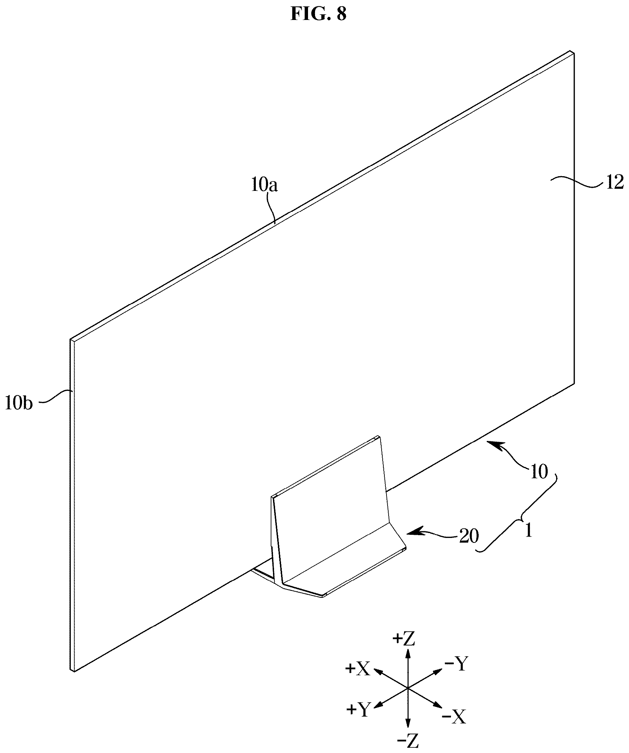

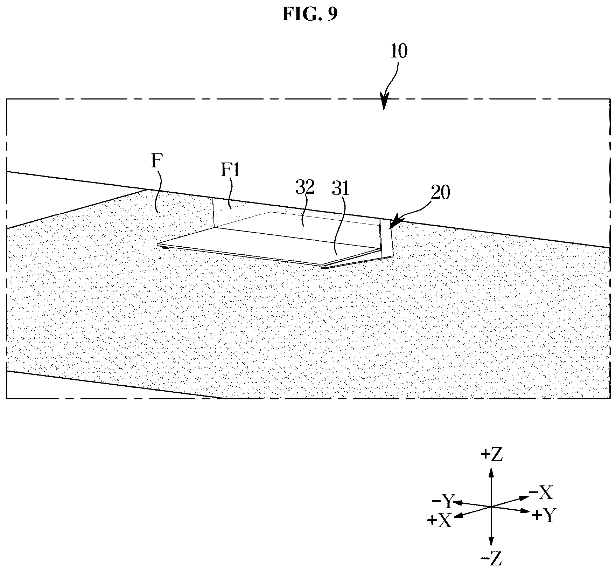

FIG. 7 is a perspective view of a display apparatus according to an embodiment. FIG. 8 is a rear perspective view of the display apparatus according to an embodiment. FIG. 9 is an enlarged view of a portion of the display apparatus according to an embodiment.

Referring to FIGS. 7 and 8, the display apparatus 1 according to an embodiment may include the display 10 that displays the screen 11 and a stand 20 provided to support the display 10.

The display 10 may include the case 12 provided to cover the edge and the rear surface of the screen 11. The display 10 may be provided to have the long side 10a and the short side 10b. The display 10 may be provided in a rectangular plate shape. However, the present disclosure does not exclude that the display 10 may be provided in a square plate shape.

The stand 20 may support the display 10 such that the display apparatus 1 may stand on its own on the floor F. The stand 20 may be coupled to the rear surface of the display 10. In response to the stand 20 being coupled to the display 10, the display 10 may maintain the screen 11 facing forward.

The stand 20 may include a stand base 30 provided to rest on the floor F, and a stand neck 40 provided to connect the display 10 and the stand base 30.

The stand base 30 may include an inclined portion 31 disposed to be inclined at a predetermined angle with respect to the floor F. The stand neck 40 may include a reflective portion 41 connected to the inclined portion 31 so as to be disposed perpendicular to the inclined portion 31. The inclined portion 31 may indicate at least a portion of an upper surface of the stand base 30. The reflective portion 41 may indicate at least a portion of a front surface of the stand neck 40 or a configuration coupled to the front surface of the stand neck 40.

Referring to FIG. 9, when the display apparatus 1 stands on its own, the presence of the stand 20 may be reduced or eliminated so that the user may focus solely on the screen 11 of the display 10.

As described above, the inclined portion 31 of the stand base 30 may be disposed to be inclined at an angle predetermined by experiments and studies with respect to the floor F. The reflective portion 41 of the stand neck 40 may be arranged perpendicular to the inclined portion 31, and the reflective portion 41 may be arranged to reflect the inclined portion 31. The reflective portion 41 may be configured to reflect and illuminate an object located in front of the reflective portion 41. The reflective portion 41 may include a metal mirror or a glass mirror formed by polishing a surface of a metal.

As the inclined portion 31 is disposed to be inclined at a predetermined angle with respect to the floor F, the reflective portion 41 is connected perpendicularly to the inclined portion, and the reflective portion 41 reflects an object located in front of the reflective portion 41, the display 10 may appear to be floating over the floor F to the user looking at the display apparatus 1 from the front. In other words, to the user, the inclined portion 31, which is a portion of the stand base 30, may be placed on the floor F, and the display 10 may appear to be floating. To the user, the stand neck 40 connecting the stand base 30 and the display 10 may appears as if it does not exist. As a result, the presence of the stand 20 may disappear, and the user may focus solely on the screen 11 of the display 10.

Referring to FIG. 9, when the user looks at the stand 20 from the front, the floor F on which the stand 20 is placed, the inclined portion 31 that is a portion of the stand 20, an inclined portion 32 reflected by the reflective portion 41, and the floor F1 reflected by the reflective portion 41 may be seen by the user. In other words, the stand neck 40 may not be visible to the user, but the inclined portion 32 and the floor F1 reflected by the reflective portion 41 of the stand neck 40 may be visible.

Because the reflective portion 41 of the stand neck 40 reflects the inclined portion 31 and the floor F, the stand neck 40 may not be visible to the user looking at the stand 20. The user may see the inclined portion 31, the reflective inclined portion 32, the floor F, and the reflective floor F1, wherein the inclined portion 31 and the reflective inclined portion 32 may appear to be connected as if they were a single plate, and the floor F and the reflective floor F1 may appear to surround the inclined portion 31 and the reflective inclined portion 32. As a result, to the user, the stand 20 may appear to be a plate placed on the floor. In this case the floor may refer to the floor F and the reflective floor F1, which appear to be connected to each other, and the plate may refer to the inclined portion 31 and the reflective inclined portion 32, which appear to be a single plate. The inclined portion 31 and the reflective inclined portion 32 may appear to be a single plate, and the single plate may appear to be placed on the floor F and the reflective floor F1, which appear to be the same floor.

As the stand 20 appears to be a plate placed on the floor, the display 10 may appear to float above the plate. By making the display 10 appear to be floating on the plate placed on the floor, the presence of the stand 20, which was present as a dark silhouette at the lower end portion of the display apparatus 1, may disappear, thereby creating the effect that the display 10 appears to be floating in the air. The disappearance or reduced presence of the stand 20 may allow the user to focus more on the screen 11 of the display 10, which is the essence of the display apparatus 1.

To achieve the above effect, the inclined portion 31 of the stand base 30 may be disposed to be inclined at an angle predetermined by studies and experiments with respect to the floor F, and the reflective portion 41 of the stand neck 40 and the inclined portion 31 may be connected at exactly 90°. By connecting the reflective portion 41 and the inclined portion 31 at exactly 90°, the sides of the inclined portion 31 and the reflective inclined portion may be connected in a straight line such that the inclined portion 31 and the reflective inclined portion 32 appear to be a single plate. By arranging the inclined portion 31 to be inclined at a predetermined angle with respect to the floor F, the user or unnecessary objects may not be reflected in the reflective portion 41, thereby creating the effect of the display 10 floating in the air.

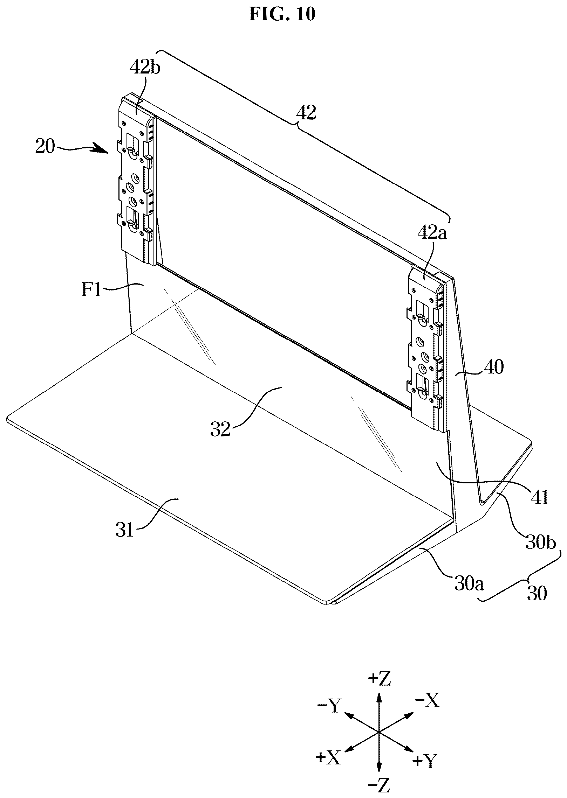

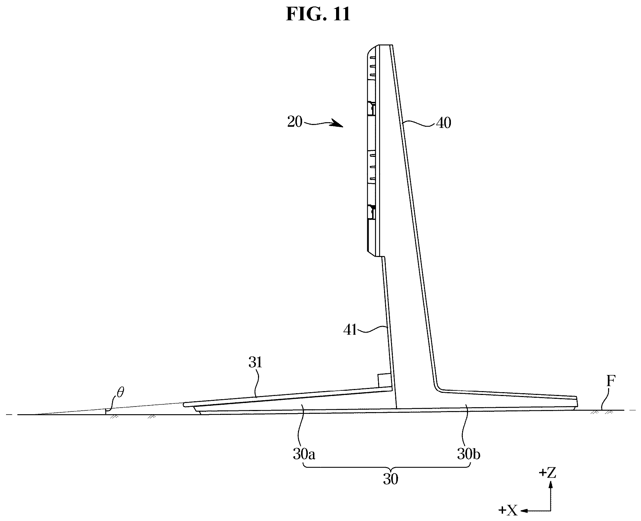

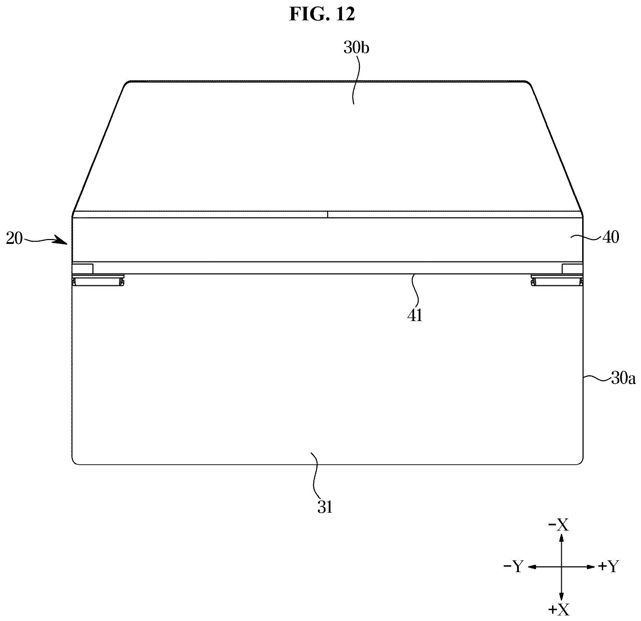

FIG. 10 is a perspective view of the stand of the display apparatus according to an embodiment. FIG. 11 is a side view of the stand of the display apparatus according to an embodiment. FIG. 12 is a top view of the stand of the display apparatus according to an embodiment.

Referring to FIGS. 10 to 12, a structure of the stand 20 configured to reduce the presence of the stand 20 in the display apparatus 1 will be described as an example.

Referring to FIG. 10, the stand 20 according to an embodiment may include a stand base 30 arranged to be placed on the floor F, and the stand neck 40 arranged to connect the display 10 and the stand base 30.

The stand base 30 may be arranged to be in contact with the floor F. The stand base 30 may be in contact with the floor F by being placed on the floor F.

As shown in FIG. 11, the stand base 30 may be arranged such that its lower surface is in contact with the floor F.

According to an embodiment, the stand base 30 may include a front base 30a disposed on a front side of the stand neck 40 and a rear base 30b disposed on a rear side of the stand neck 40. A lower surface of the front base 30a and a lower surface of the rear base 30b may be disposed in the same plane. The lower surface of the front base 30a and the lower surface of the rear base 30b may be arranged to contact the floor F. In such a configuration, the entire lower surface of the stand base 30 may be in contact with the floor F, so that the stand 20 may support the display 10 more stably. Alternatively, a portion of the lower surface of the front base 30a and a portion of the lower surface of the rear base 30b may each be arranged to contact the floor F. For example, a front end of the lower surface of the front base 30a and a rear end of the lower surface of the rear base 30b may each be arranged to contact the floor F. In this case, the upper and lower surfaces of the front base 30a may each be disposed to be inclined with respect to the floor F. Similarly, the upper and lower surfaces of the rear base 30b may each be disposed to be inclined with respect to the floor F.

The upper surface of the front base 30a may indicate the inclined portion 31 described above. According to an embodiment, the upper surface of the front base 30a may have a rectangular shape. However, there is no limitation on the shape of the upper surface of the front base 30a. For example, the upper surface of the front base 30a may have variety of shapes.

Referring to FIG. 12, the rear base 30b may be provided such that its width gradually narrows toward the rear. The width of the rear base 30b may refer to a length of the rear base 30b in the left-to-right direction. Although not shown in the drawings, the rear base 30b may be arranged to include a portion whose width gradually narrows toward the rear. In this case, the rear base 30b may include a section whose width narrows toward the rear from a front end of the rear base 30b connected to the stand neck 40, and after the section, the width may be constant or wider.

The stand neck 40 may be arranged to be coupled to the case 12 of the display 10. The stand neck 40 may connect the display 10 and the stand base 30. The stand neck 40 may be formed integrally with the stand base 30 or may be arranged to be coupled to the stand base 30.

The stand neck 40 may include a coupling portion 42 arranged to be coupled to the case 12 of the display 10. The coupling portion 42 may be provided on the front surface of the stand neck 40. The coupling portion 42 may include a first coupling portion 42a provided on one side of the stand neck 40 and a second coupling portion 42b provided on the other side of the stand neck 40. Although not shown in the drawings, the case 12 of the display 10 may be formed with a first coupling groove into which the first coupling portion 42a is inserted, and a second coupling groove into which the second coupling portion 42b is inserted. After the first coupling portion 42a is inserted into the first coupling groove and the second coupling portion 42b is inserted into the second coupling groove, the stand neck 40 and the display 10 may be coupled using a fastening member (not shown). In addition to using the fastening member, the stand neck 40 and the display 10 may be coupled by various known methods.

The stand neck 40 may be provided with the reflective portion 41 on the front surface thereof. The reflective portion 41 may be a metal mirror formed by polishing the surface of metal. For example, the reflective portion 41 may be a stainless steel super mirror. That is, the reflective portion 41 may be made of stainless steel with a surface treatment.

The reflective portion 41 may also be provided as a glass mirror. In this case, the reflective portion 41 may be configured to be attached to the front surface of the stand neck 40.

The reflective portion 41 may be connected to the inclined portion 31. The reflective portion 41 and the inclined portion 31 may be connected by contacting a lower end of the reflective portion 41 with the inclined portion 31. The reflective portion 41 may be disposed at an angle of 90° to the inclined portion 31. In other words, the reflective portion 41 may be disposed perpendicular to the inclined portion 31.

In the display apparatus 1 according to the present disclosure, the inclined portion 31 may be disposed to be inclined at a predetermined angle with respect to the floor F. In particular, the inclined portion 31 may be arranged to be inclined at an angle of 5° or less with respect to the floor F. The predetermined angle described above may refer to an angle of 5°. The fact that the inclined portion 31 is disposed to be inclined at an angle of 5° or less with respect to the floor F may refer to that the acute angle θ between the inclined portion 31 and the floor F is 5° or less.

The angle between the inclined portion 31 and the floor F may be determined by various experiments and studies. The angle may be determined by a number of experiments based on various variables, such as an average viewing height and a suitable viewing distance. According to the present disclosure, the angle between the inclined portion 31 and the floor F may be determined by comprehensively considering the height of the furniture on which the display apparatus 1 is placed, the height of the user's gaze when the user sits on a couch, the size of the screen 11 of the display apparatus 1, a distance between the display apparatus 1 and the user, the average height of the user, and the like. Through a series of experiments considering these variables, the angle between the inclined portion 31 and the floor F may be determined to be 5° or less.

As the angle between the inclined portion 31 and the floor F becomes greater than 5°, the size of the reflective inclined portion 32 reflected by the reflective portion 41 may gradually increase. In response to the angle between the inclined portion 31 and the floor F exceeding the certain value, only the inclined portion 31 may be reflected by the reflective portion 41. In order for the display 10 to appear to be floating, the reflective floor F1 is required to be reflected by the reflective portion 41. As described above, as the angle between the inclined portion 31 and the floor F becomes greater than 5°, the reflective floor F1 on the reflective portion 41 may become too small or not be visible at all, so that the display 10 may not appear to be floating. Accordingly, it is difficult to make the presence of the stand 20 disappear.

In the display apparatus 1 according to the present disclosure, the angle between the inclined portion 31 and the floor F may be set to 5° or less, so that the display 10 may appear to be floating, the presence of the stand 20 may disappear, and the user may focus on the screen 11 of the display 10.

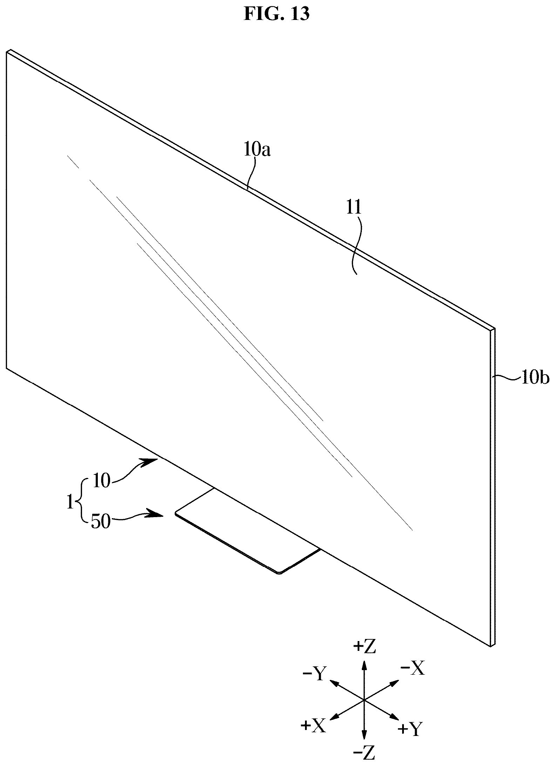

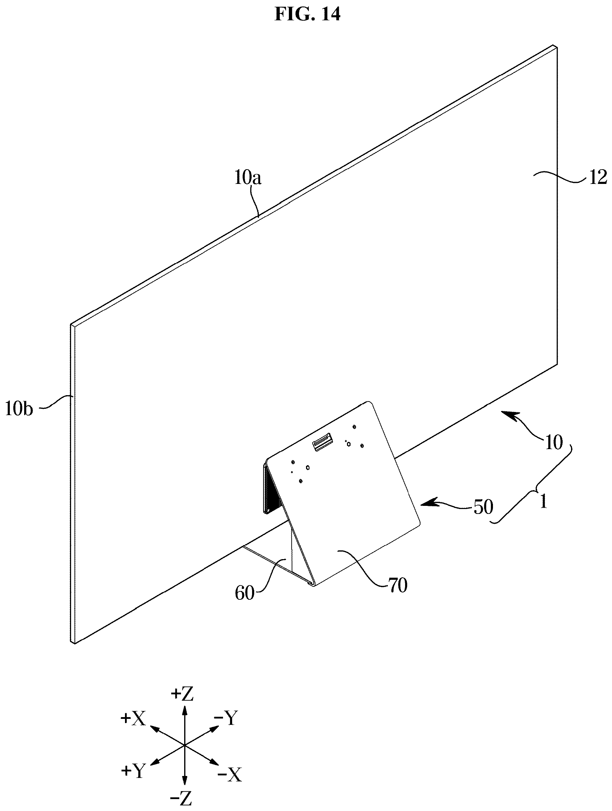

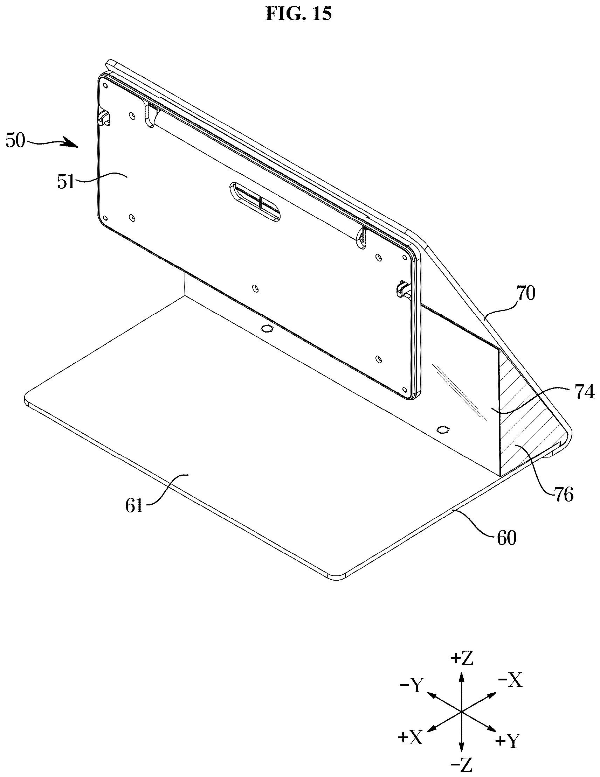

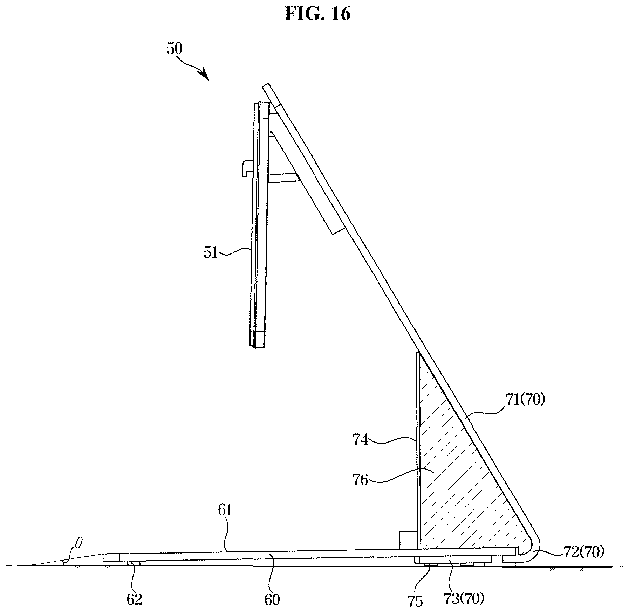

FIG. 13 is a perspective view of a display apparatus according to an embodiment. FIG. 14 is a rear perspective view of the display apparatus according to an embodiment. FIG. 15 is a perspective view of a stand of the display apparatus according to an embodiment. FIG. 16 is a side view of the stand of the display apparatus according to an embodiment.

Hereinafter, the display apparatus 1 according to an embodiment will be described with reference to FIGS. 13 to 16.

Referring to FIGS. 13 and 14, the display apparatus 1 may include the display 10 configured to display the screen 11 and a stand 50 provided to support the display 10.

The display 10 may include a self-emissive display panel or a non-emissive display panel, and the case 12 arranged to cover the edge and the rear surface of the display panel. The display 10 may be provided to have the long side 10a and the short side 10b, but alternatively, the display 10 may be provided to have all four sides of equal length.

The stand 50 may include a stand base 60 provided to be in contact with the floor surface F, and a stand neck 70 provided to connect the display 10 and the stand base 60.

According to an embodiment, the stand 50 may include the stand neck 70 and a coupling member 51 provided to be coupled to the display 10. The coupling member 51 may be arranged to be coupled to the case 12 of the display 10 and may be rotatably connected to the stand neck 70. The coupling member 51 may be coupled to be fixedly secured to the case 12 by a fastening member (not shown). The coupling member 51 may be rotatably hinge-coupled to the stand neck 70. The display 10 and the stand neck 70 may be connected via the coupling member 51.

The stand neck 70 includes a neck 71 extending at an angle from the rear surface of the display 10 toward the floor F, a bent portion 72 formed by bending at a lower end of the neck 71, and an extension portion 73 extending from the bent portion 72.

The neck 71 may be disposed at an inclined angle with respect to the floor F. The angle between the neck 71 and the floor F may be predetermined to be less than 90°. The coupling member 51 may be coupled to one side of the neck 71 adjacent to an upper end of the neck 71.

The bent portion 72 may connect the neck 71 and the extension portion 73. The bent portion 72 may connect the lower end of the neck 71 and a rear end of the extension portion 73. According to an embodiment, the neck 71, the bent portion 72, and the extension portion 73 may be formed integrally. For example, a single flat plate may be bent to form the neck 71, the bent portion 72, and the extension portion 73. Alternatively, the neck 71, the bent portion 72, and the extension portion 73 may be provided separately and coupled together, or the neck 71 and the bent portion 72 may be formed integrally and the extension portion 73 may be coupled to the bent portion 72.

The extension portion 73 may be provided substantially parallel to the floor F. The stand base 60 may be coupled to the extension portion 73. At least a portion of the stand base 60 may be disposed on an upper side of the extension portion 73. In particular, a rear side of the stand base 60 may be disposed on the upper side of the extension portion 73. This may allow the stand base 60 to be positioned at an inclined angle with respect to the floor F at a predetermined angle.

A first support 62 may be provided on a lower surface of a front side of the stand base 60 to be in contact with the floor F. The first support 62 may be arranged to contact the floor F. The first support 62 may include an elastic material. The rear side of the stand base 60 may be coupled with the extension portion 73.

A second support 75 may be provided on a lower surface of the extension portion 73. The second support 75 may be arranged to contact the floor F, and, similarly to the first support 62, may include an elastic material.

By adjusting the height of the first support 62 and the second support 73 in a vertical direction, the thickness of the extension portion 73, and the length of the stand base 60 in a front-to-back direction, the inclined portion 61, which is the upper surface of the stand base 60, may be disposed to be inclined at a predetermined angle with respect to the floor F. As described above, the angle between the inclined portion 61 and the floor F may be 5° or less so as to make the presence of the stand 50 disappear.

The stand base 60 may be provided in the shape of a flat square plate. However, there is no limitation on the shape of the stand base 60. The stand base 60 may include a plate of various shapes, such as a semi-circular, polygonal, or oval shape.

According to an embodiment, the stand 50 may further include a reinforcing member 76. The reinforcing member 76 may be provided between the neck 71, the bent portion 72, the extension portion 73, and the stand base 60. The reinforcing member 76 may be disposed below the neck 71 and above the stand base 60, the extension portion 73, and the bent portion 72. The reinforcing member 76 may be arranged to fill at least a portion of a space formed between the neck 71, the bent portion 72, the extension portion 73, and the stand base 60.

The reinforcing member 76 may prevent the bent portion 72 provided at the lower end of the neck 71 from bending more than the designed angle due to the weight of the display 10. In other words, based on the angle between the neck 71 and the bent portion 72 being designed to be θ1 (not shown), which is less than 90°, the angle between the neck 71 and the bent portion 72 may be prevented from becoming smaller than θ1. Since the neck 71, which is thin and extends at an angle toward the floor F, supports the weight of the display 10, deformation of the bent portion 72 or at least a portion of the neck 71 may occur. This deformation may cause the angle between the neck 71 and the bent portion 72 to be smaller than the designed value, θ1, and to prevent such a situation, the reinforcing member 76 may be provided between the neck 71 and the bent portion 72.

According to an embodiment, the stand 50 may include a reflective portion 74 provided on a front surface of the reinforcing member 76. The reflective portion 74 may be arranged to reflect and illuminate an object located in front of the reflective portion 74. The reflective portion 74 may be a metal mirror or a glass mirror formed by polishing the surface of metal. In the case where the reinforcing member 76 is made of a metal material, the front surface of the reinforcing member 76 may be made to be the reflective portion 74 by surface treatment. Alternatively, the reflective portion 74 may be a metal mirror or a glass mirror provided separately from the reinforcing member 76, and may be attached or coupled to the front surface of the reinforcing member 76.

The reflective portion 74 may be connected to the inclined portion 61 so as to be disposed at a full angle of 90° with respect to the inclined portion 61. The lower surface of the reflective portion 74 may be connected to one side of the inclined portion 61.

As described above, the inclined portion 61 may be disposed to be inclined with respect to the floor F at an angle of 5° or less, which is an angle predetermined by experiments and studies, and the reflective portion 74 may be disposed to be inclined at an angle of 90° with respect to the inclined portion 61. As a result, the display 10 may appear to be floating to the user looking at the display apparatus 1, the presence of the stand 50 may disappear, and the user may focus on the screen 11 of the display 10.

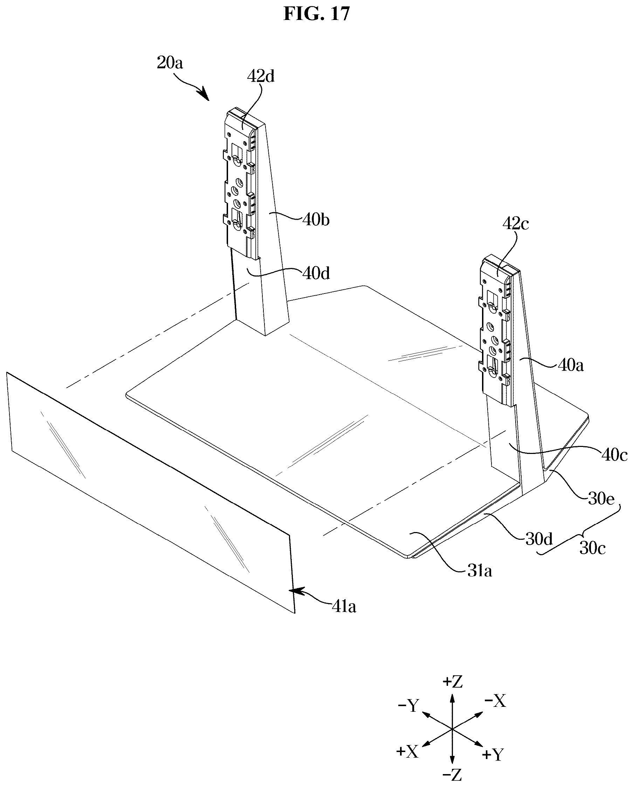

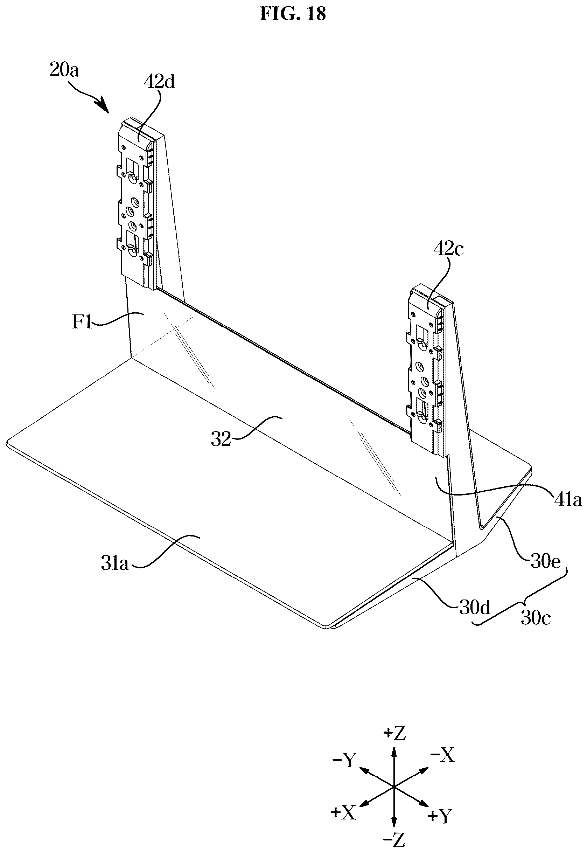

FIG. 17 is an exploded view of a stand of the display apparatus according to an embodiment. FIG. 18 is a perspective view of the stand shown in FIG. 17.

With reference to FIGS. 17 and 18, a stand 20a of the display apparatus according to an embodiment will be described.

The stand 20a according to an embodiment may include a first stand neck 40a and a second stand neck 40b spaced laterally apart, and a stand base 30c.

The first stand neck 40a may be connected to one side of the stand base 30c, and the second stand neck 40b may be connected to the other side of the stand base 30c.

The first stand neck 40a may include a first coupling portion 42c that is coupled to the rear surface of the display 10. The first coupling portion 42c may be provided on a front surface of the first stand neck 40a.

The first stand neck 40a may include a first reflective member support portion 40c to which a reflective member 41a, which will be described later, is attached or coupled. The first reflective member support portion 40c may be disposed at an angle of 90° to the inclined portion 31a. In other words, the angle between the first reflective member support portion 40c and the inclined portion 31a may be 90°.

The second stand neck 40b may include a second coupling portion 42d that is coupled to the rear surface of the display 10. The second coupling portion 42d may be provided on a front surface of the second stand neck 40b.

The second stand neck 40b may include a second reflective member support portion 40d to which the reflective member 41a, which will be described later, is attached or coupled. The second reflective member support portion 40d may be disposed at an angle of 90° to the inclined portion 31a. In other words, the angle between the second reflective member support portion 40d and the inclined portion 31a may be 90°.

The stand base 30c may include a front base 30d disposed on a front side of the first stand neck 40a and the second stand neck 40b, and a rear base 30e disposed on a rear side of the first stand neck 40a and the second stand neck 40b. However, a portion of a rear side of the front base 30d and a portion of a front side of the rear base 30e may be disposed between the first stand neck 40a and the second stand neck 40b.

The stand base 30c may include the inclined portion 31a disposed to be inclined at a predetermined angle with respect to the floor F. The inclined portion 31a may indicate at least a portion of the upper surface of the stand base 30c. In particular, the inclined portion 31a may indicate the upper surface of the front base 30d.

The rear base 30e may be provided such that its width gradually narrows toward the rear. The width of the rear base 30e may refer to a length of the rear base 30e in the left-to-right direction. Although not shown in the drawings, the rear base 30e may be provided to include a portion whose width gradually narrows toward the rear.

According to an embodiment, the stand 20a may include the reflective member 41a. The reflective member 41a may be a metal mirror formed by polishing the surface of metal. For example, the reflective member 41a may be a stainless steel super mirror. The reflective member 41a may be made of stainless steel with a surface treatment. Alternatively, the reflective member 41a may be a glass mirror.

The reflective member 41a may be attached or coupled to the first reflective member support portion 40c of the first stand neck 40a and the second reflective member support portion 40d of the second stand neck 40b. The reflective member 41a may be attached to the first reflective member support portion 40c and the second reflective member support portion 40d by an adhesive member (not shown). Alternatively, the reflective member 41a may be coupled to the first reflective member support portion 40c and the second reflective member support portion 40d by a fastening member (not shown).

Referring to FIG. 18, after the reflective member 41a is attached or coupled to the first reflective member support 40c and the second reflective member support 40d, the reflective member 41a and the inclined portion 31a may be positioned at a full angle of 90°. In addition, a lower end of the reflective member 41a and the inclined portion 31a may be connected.

The inclined portion 31a may be disposed to be inclined at a predetermined angle with respect to the floor F. As described above, the angle between the inclined portion 31a and the floor F may be 5° or less so as to make the presence of the stand 20a disappear.

The inclined portion 31a may be disposed to be inclined with respect to the floor surface F at an angle of 5° or less, which is an angle predetermined by experiments and studies, and the reflective member 41a may be disposed at 90° with respect to the inclined portion 31a. As a result, the display 10 may appear to be floating to the user looking at the display apparatus 1, the presence of the stand 20a may disappear, and the user may focus on the screen 11 of the display 10.

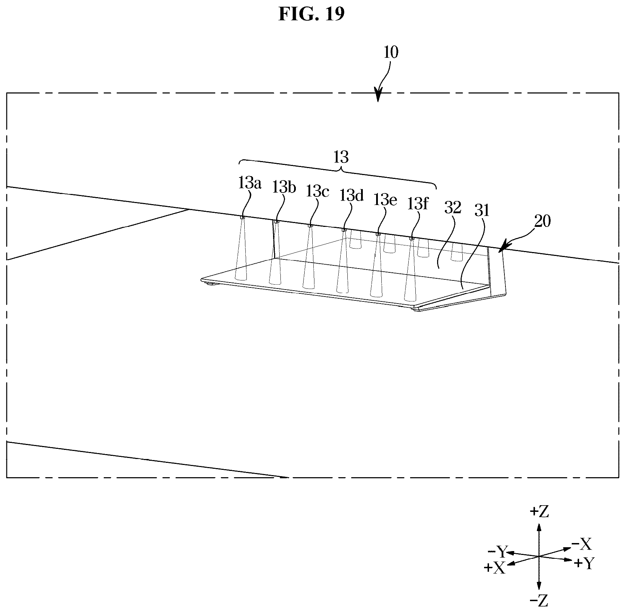

FIG. 19 is an enlarged view of a portion of the display apparatus according to an embodiment.

Referring to FIG. 19, the display 10 according to an embodiment may include a plurality of light emitting portions 13 at a lower end portion of the display 10 positioned on an upper side of the inclined portion 31.

The number of the plurality of light emitting portions 13 is not limited, but as an example, the plurality of light emitting portions 13 may include a first light emitting portion 13a, a second light emitting portion 13b, a the third light emitting portion 13c, a fourth light emitting portion 13d, a fifth light emitting portion 13e, and a sixth light emitting portion 13f.

The plurality of light emitting portions 13 may be provided at the lower end portion of the display 10 to be spaced apart from each other, so that light emitted from the plurality of light emitting portions 13 may illuminate the inclined portion 31. The reflective inclined portion 32 may also be illuminated with the light emitted from the plurality of light emitting portions 13, as well as may the inclined portion 31. Accordingly, the inclined portion 31 and the reflective inclined portion 32 may be illuminated, which may be an element that gives an aesthetic feeling to the user.

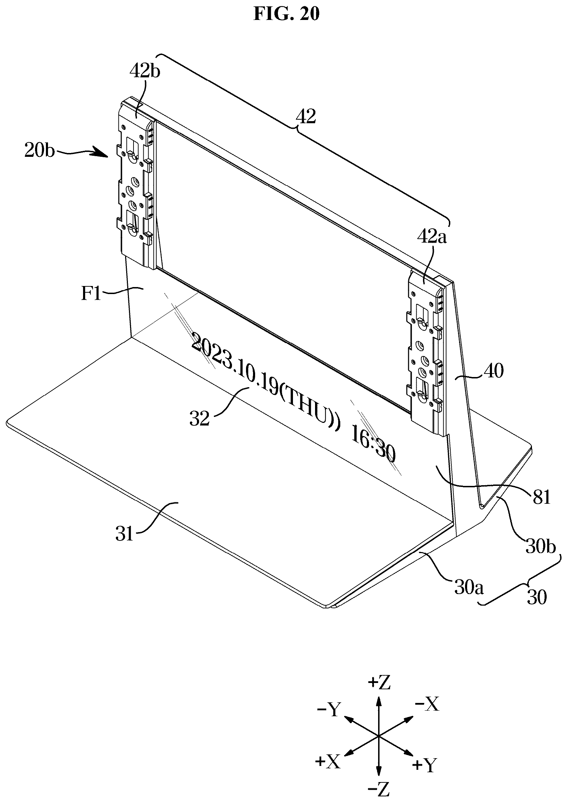

FIG. 20 is a perspective view of a stand of a display apparatus according to an embodiment.

Referring to FIG. 20, a stand 20b according to an embodiment may include the same configuration as the stand 20 shown in FIGS. 7 to 10, except for a display portion 81. The stand 20b may also include the same configuration as the stand 100 shown in FIGS. 4 to 6, except for the display portion 81.

The stand 20b may include the display portion 81 provided on the front surface of the stand neck 40. The display portion 81 may include a switchable mirror display.

The display portion 81 may operate in a mirror mode or a transparent display mode. The display apparatus 1 may include a controller (not shown) configured to control the display portion 81, and based on a control signal from the controller, the display portion 81 may operate in the mirror mode or the transparent display mode. The controller may control the reflectivity of the display portion 81 to be maximized when in the mirror mode, and may control the reflectivity of the display portion 81 to be reduced when in the transparent display mode so that the screen is visible from the front by the display panel disposed inside the display portion 81.

When the display portion 81 is operated in the mirror mode, similar to the stand 20 shown in FIGS. 4 to 6, the display portion 81 may reflect the inclined portion 31 and the floor F.

When the display portion 81 is operated in the transparent display mode, the display portion 81 may display various information with a lower reflectivity. For example, the display portion 81 may display date, time, and day of the week information, as shown in FIG. 20. Although not shown in the drawings, the display portion 81 may display news, stock information or the like in a stationary state or in a scrolling in the vertical or lateral directions. In addition, the display portion 81 may display information about the content being displayed on the display 10 (e.g., title, current playback time/total playback time, and the like), and information about the control state of the display 10 (e.g., volume value when volume is adjusted, channel number when channels are controlled, off/on scheduling, time display, changes to the settings of the display, and the like). In addition, the display portion 81 may display alarm messages (e.g., information about the control status of devices associated with to the display). In addition, the display portion 81 may display a manufacturer's logo.

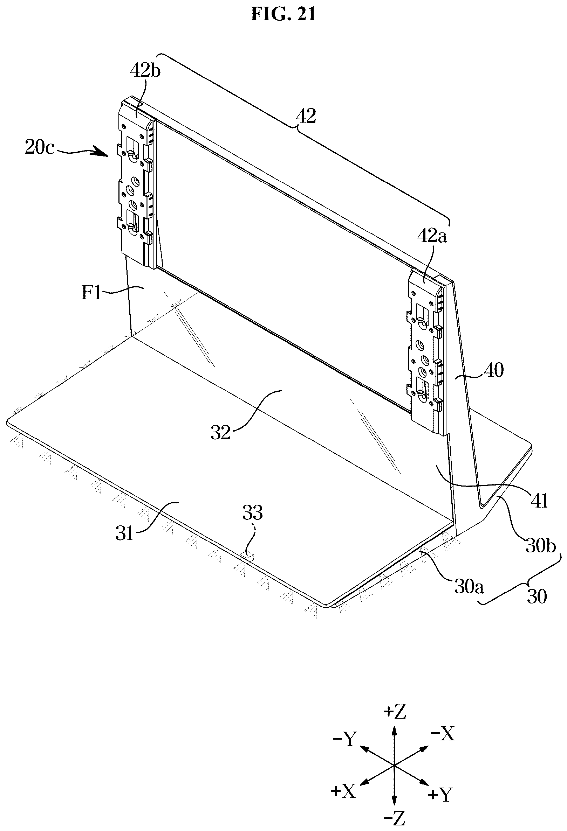

FIG. 21 is a perspective view of a stand of the display apparatus according to an embodiment.

Referring to FIG. 21, a stand 20c according to an embodiment may include the same configuration as the stand 20 shown in FIGS. 7 to 10, except for a plurality of stand light emitting portions 33. The stand 20c may also include the same configuration as the stand 100 shown in FIGS. 4 to 6, except for the display portion 81.

Referring to FIG. 21, the stand 20c may include the plurality of stand light emitting portions 33 spaced apart along an edge of the stand base 30. In particular, the plurality of stand light emitting portions 33 may be arranged to be spaced apart along the edge of the front base 30a.

Since the plurality of stand light emitting portions 33 are arranged to be spaced apart from each other along the edge of the front base 30a, light emitted from the plurality of stand light emitting portions 33 may illuminate the floor F. The light emitted from the plurality of stand light emitting portions 33 may also illuminate the reflective floor F1 as well as on the floor F1. Accordingly, the floor F and the reflective floor F1 may be illuminated by light, and the display apparatus 1 may appear as if the display 10 is floating on a single plate that emits light along the edge. This may give an aesthetic impression to the user.

According to an embodiment of the disclosure, a display apparatus includes a stand configured to support a display, the stand including a stand base configured to be supported on a support surface, the stand base including an inclined portion configured to be inclined at a predetermined angle with respect to the support surface when the stand base is supported on the support surface, and a stand neck configured to connect a rear surface of the display and the stand base to support the display on the stand, the stand neck including a reflective portion that is connected to the inclined portion so that the reflective portion is perpendicular to the inclined portion, wherein the reflective portion is configured to reflect the inclined portion.

The predetermined angle of the inclined portion may be an angle at which the inclined portion and the support surface are each reflected by the reflective portion when the stand base is supported on the support surface.

The inclined portion and the reflective portion may be configured so that, when the stand base is supported on the support surface and the display is supported on the stand, the display appears to be floating above the inclined portion based on the inclined portion and the support surface being reflected by the reflective portion.

The predetermined angle of the inclined portion may be 5° or less.

The inclined portion may be an upper surface of at least a portion of the stand base in front of the stand neck.

The reflective portion may be at least a portion of a front surface of the stand neck.

The stand base may include a front base in front of the stand neck, and a rear base at a rear of the stand neck.

The rear base may be configured to include a portion that is tapered toward a rear of the rear base in a left-to-right direction.

The stand neck may include an extension portion configured to be coupled to the stand base, and a neck connected to the extension portion so as to extend upward from the stand base to be connected to the display to support the display on the stand.

An angle between the neck and the support surface may be less than 90°.

A first side of the reflective portion may be connected to the inclined portion, and a second side of the reflective portion may be connected to the neck, so that the reflective portion is perpendicular to the inclined portion.

The stand neck may include a first stand neck connected to a first side of the stand base, and a second stand neck connected to a second side of the stand base.

The reflective portion may be coupled to the first stand neck and the second stand neck so as to cover the first stand neck, the second stand neck, and a space between the first stand neck and the second stand neck.

The display apparatus may include the display.

The display may include a plurality of light emitting portions spaced apart along a lower end portion of the display.

The reflective portion may include a switchable mirror display that is operable in a mirror mode or a transparent display mode.

The stand base may include a plurality of stand light emitting portions spaced apart from each other along an edge of at least a portion of the stand base.

The reflective portion may be a mirror covering at least a portion of a front surface of the stand neck.

According to various embodiments of the present disclosure, the display apparatus may be provided to allow the user to focus on the screen of the display by reducing the presence of the stand.

While the present disclosure has been particularly described with reference to exemplary embodiments, it should be understood by those of skilled in the art that various changes in form and details may be made without departing from the spirit and scope of the present disclosure.

## Claims

1. A display apparatus, comprising:
a stand configured to support a display, the stand including:
a stand base configured to be supported on a support surface, the stand base including an inclined portion configured to be inclined at a predetermined angle with respect to the support surface when the stand base is supported on the support surface, and
a stand neck configured to connect a rear surface of the display and the stand base to support the display on the stand, the stand neck including a reflective portion that is connected to the inclined portion so that the reflective portion is perpendicular to the inclined portion,
wherein the reflective portion is configured to reflect the inclined portion.

2. The display apparatus of claim 1, wherein
the predetermined angle of the inclined portion is an angle at which the inclined portion and the support surface are each reflected by the reflective portion when the stand base is supported on the support surface.

3. The display apparatus of claim 2, wherein
the inclined portion and the reflective portion are configured so that, when the stand base is supported on the support surface and the display is supported on the stand, the display appears to be floating above the inclined portion based on the inclined portion and the support surface being reflected by the reflective portion.

4. The display apparatus of claim 1, wherein
the predetermined angle of the inclined portion is 5° or less.

5. The display apparatus of claim 1, wherein
the inclined portion is an upper surface of at least a portion of the stand base in front of the stand neck.

6. The display apparatus of claim 1, wherein
the reflective portion is at least a portion of a front surface of the stand neck.

7. The display apparatus of claim 1, wherein
the stand base includes:
a front base in front of the stand neck, and
a rear base at a rear of the stand neck,
wherein the rear base is configured to include a portion that is tapered toward a rear of the rear base in a left-to-right direction.

8. The display apparatus of claim 1, wherein
the stand neck includes:
an extension portion configured to be coupled to the stand base, and
a neck connected to the extension portion so as to extend upward from the stand base to be connected to the display to support the display on the stand,
wherein an angle between the neck and the support surface is less than 90°.

9. The display apparatus of claim 8, wherein
a first side of the reflective portion is connected to the inclined portion, and a second side of the reflective portion is connected to the neck, so that the reflective portion is perpendicular to the inclined portion.

10. The display apparatus of claim 1, wherein
the stand neck includes:
a first stand neck connected to a first side of the stand base, and
a second stand neck connected to a second side of the stand base, and
the reflective portion is coupled to the first stand neck and the second stand neck so as to cover the first stand neck, the second stand neck, and a space between the first stand neck and the second stand neck.

11. The display apparatus of claim 1, further comprising:
the display,
wherein the display includes a plurality of light emitting portions spaced apart along a lower end portion of the display.

12. The display apparatus of claim 1, wherein
the reflective portion includes a switchable mirror display that is operable in a mirror mode or a transparent display mode.

13. The display apparatus of claim 1, wherein
the stand base includes a plurality of stand light emitting portions spaced apart from each other along an edge of at least a portion of the stand base.

14. The display apparatus of claim 1, wherein
the reflective portion is a mirror covering at least a portion of a front surface of the stand neck.
